# EUROPEAN PATENT APPLICATION

(11) **EP 0 561 713 A2**
(43) Date of publication of application: **22.09.1993**
(21) Application number: 93400717.0
(22) Date of filing: 22.03.1993
(51) Int. Cl.: G01R 11/04

(54) **Induction watt hour meter rotary disc mounting and bearing system**

(30) Priority: 20.03.1992 CA 2063617
(71) Applicant: SCHLUMBERGER CANADA LIMITED, Toronto Ontario M4G 3X1 (CA)
(72) Inventor: Hartman, Marinus, Pickering, Ontario, Canada, L1W 1G5 (CA); Roig, Alain, 1701 Toronto, Ontario, Canada, M4K 3X9 (CA); Howell, Chesley R., Scarborough, Ontario, Canada, M1J 2J4 (CA)
(74) Representative: Hawkes, David John

(57) **Abstract**

An electro-mechanical induction watt hour meter bearing system that includes end cap pilot bearings snap fit onto respective opposite ends of the shaft. The bearing system also includes a lower shaft support bearing selectively adjustable in increments for controlled adjustment.

## Description

### Field of Invention

This invention relates to a bearing system for the rotor of an electro-mechanical induction watt hour meter.

### Background of Invention

Watt hour meters most commonly used as electric energy billing meters are the simple induction electro-mechanical meters. These meters have proven to have a high degree of accuracy and reliability through many years of service under varying ambient operating conditions. The reliability of these meters is exemplified by the fact accrediting authorities in Canada require only sample testing from which a number of meters can be sealed for a period of twelve years and this can be extended for periods of up to eight years indefinitely depending upon the accuracy criteria.

The watt hour meter has a motor whose torque is proportional to the power flowing through it, a magnetic brake to retard the speed of the motor in such a way that it is proportional to power (by making the braking effect proportional to the speed of the meter's rotor), and a register to count the number of revolutions the motor makes.

The rotor portion of the meter motor includes an electrical conductor in the form of a disk which is placed between the pole faces of the stator. Magnetic fluxes induce emf's in the disk which cause eddy currents that react with the alternating magnetic field, causing torque on the disk. The disk is free to turn, so it rotates. Since this torque tends to cause constant acceleration, brake magnets are placed around the disk. The strength of the magnet is chosen so that the retarding torque will balance the driving torque at a given speed.

In the existing art, the basic parts of the meter are assembled on a frame, mounted on a base, and then covered with a glass cover. The purpose of the frame is to hold in fixed relation the current stator, potential stator, disk, brake magnets and the register.

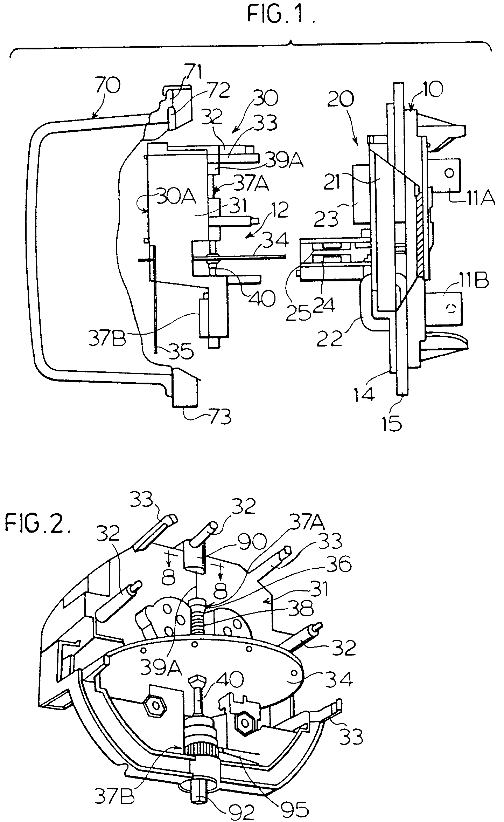

In order to support the shaft (spindle) on which the rotor is mounted, bearings that give a minimum amount of friction are used. In existing meters there is an upper bearing and a lower bearing each slidably mounted in a bore on the frame and each slidable bearing is held by a set screw. This construction is clearly illustrated in Figure 2 of U.S. Patent 3,881,0̸70̸ issued November 14, 1989 to Burrowes et al. In each bearing is mounted a flexible guide pin (pintle) of a length which is non-resonant to any vibration frequencies encountered from no-load to maximum load. The upper and lower ends of the disk spindle are centered by graphite or polymide rings (pilot bearings) that are inserted into recesses in respective opposite ends of the shaft. These pilot bearings function as the bearing surface for the guide pivots.

The spindle assembly is supported by the mutual repulsion of two magnets, one being attached to the shaft for rotation therewith and the other mounted in the lower bearing assembly. These are referred to as upper and lower magnets and there is a temperature compensator associated with the lower magnet. The only bearing pressures in this type of rotor support are slight side thrusts on the guide pins (pintles) since the shaft does not otherwise generally touch either the top or bottom supports.

In the existing meters the disk is centered between the brake magnets and stators by vertically moving the upper and lower bearings and using the set screws to lock the bearings in position. It is difficult and awkward to hold the bearing in the desired location while at the same time tightening the set screw and it is furthermore difficult to gage the distance that the bearing, and hence the disk, has travelled in each adjustment. The adjustment becomes a tedious trial and error task with no predictability to repetitive adjustments.

### Summary of Invention

In accordance with one aspect of the present invention there is provided a bearing system for the rotor of an electro-mechanical induction watt hour meter wherein the rotor includes a shaft having a disc mounted thereon for rotation therewith, said bearing system comprising a pair of end cap pilot bearings secured to respective opposite ends of the shaft, said end cap pilot bearings having a pintle receiving aperture disposed in axial alignment with the axis of rotation of the shaft.

In accordance with a further aspect of the present invention there is provided a bearing system for the rotor of an electro-mechanical induction watt hour meter wherein the rotor includes a disk secured to a shaft for rotation therewith, said bearing system comprising a pair of end cap pilot bearings secured to a respective one of opposite ends of the shaft, said end cap pilot bearings having a pintle receiving aperture disposed in axial alignment with the axis of rotation of the shaft and a magnetic bearing support means at the lower end of the shaft comprising a first and second permanent magnet secured respectively to said shaft and an adjustable support means.

In accordance with a further aspect of the present invention there is provided an electro-mechanical induction watt hour meter having a rotor comprising a shaft with a disk secured thereto for rotation therewith and a lower magnetic bearing means supporting said rotor, said magnetic bearing means comprising an upper and a lower permanent magnet secured respectively to said shaft and a bearing support means and means mounting said bearing support means for selective controllable adjustment.

### List of Drawings

The invention is illustrated by way of example in the accompanying drawings wherein:
Figure 1 is an exploded side elevational view illustrating the major components of the electro-mechanical induction watt hour meter;
Figure 2 is an oblique view of the rotor mounted on a housing support for the same and the register;
Figure 3 is an exploded view of the rotor and bearing support assemblies for the same;
Figure 4 is a partial sectional, partially exploded, view of the rotor shaft and pilot bearings for the respective opposite ends thereof;
Figure 5 is an end view of one of the pilot bearings;
Figure 6 is an enlarged sectional view of an end of the rotor shaft and pilot bearing secured thereto;
Figure 7 is an exploded view of the lower support bearing for the shaft;
Figure 8 is a sectional view taken essentially along line 8-8 of Figure 2; and
Figure 9 is a sectional view taken essentially along line 9-9 of Figure 3.

### Description of Preferred Embodiments

Figure 1 is an exploded view illustrating applicant's electro-mechanical induction watt hour meter having a base 10̸, an electro-magnetic unit 20̸ with a diskbrake magnet mounted thereon, a register and rotor unit 30̸ and a glass cover 70̸. The rotor of register and rotor unit 30̸ is indicated generally at 12.

The electro-magnetic unit 20̸ has a core unit 21 with respective current and potential coils 22 and 23 mounted thereon. A magnetic brake 24 is carried by the unit 20̸ and has a gap 25 for receiving a portion of a rotor disk 34. The unit 20̸ securely attaches to the molded base 10̸ and has pairs of current terminals 11A and 11B projecting therefrom. There are two current coils and each has two terminals.

Base 10̸ may be molded conventionally from a hard plastics material i.e. thermoset plastics such as a phenolic resin (Bakelite*) or preferably from a rigid thermoplastic resin. Applicant's preferred material is a polycarbonate material identified as #9417 Makrolon* polycarbonate available from Bayer Company of Germany. The polycarbonate is preferably glass reinforced (about 10̸% glass) and ultraviolet light stabilized.
*Trade-Mark

The magnetic coil unit 20̸ attaches to the base in a convenient manner, for example, lugs projecting from the base which position and snap fit onto the unit 20̸.

The register and rotor 30̸ unit is a module that snap fits and locks onto the coil unit 20̸ and includes a molded plastics housing (preferably Ryton* PPS) 31 having a plurality of spacer lugs 32 projecting therefrom and attaching lugs 33 for precisely locating unit 30̸ relative to unit 20̸ and attaching unit 30̸ to the previously assembled base 10̸ and coil unit 20̸. The unit 30̸ has a register diagrammatically illustrated by its face designated 30̸A and a name plate 35 that attaches to and extends downwardly from the molded plastic housing 31. The locating lugs 32 position the unit 30̸ relative to unit 20̸ such that a rotatable disk 34 on the unit 30̸ projects into the coil gap 25 and, as previously mentioned, lugs 33 snap fasten onto the coil unit 20̸ and/or base unit 10̸.

With reference to figure 2, the disk 34, which is caused to rotate by the electro-magnetic unit 20̸ in a known manner, is mounted on a shaft or spindle 40̸ that is journalled on the housing 31 by respective upper and lower bearing assemblies 37A and 37B. A pintle 39A, which is part of the upper bearing assembly 37A, projects into a pintle receiving unit 39A on the molded plastic housing 31. The rotor shaft 40̸ has a worm sear 38 on the upper end thereof that meshes with a drive gear (not shown) for the register unit which, via dials, visually indicates the cumulative energy consumed.

Returning to figure 1, the glass cover 70̸ has an outwardly directed flange 71 with a seat portion 72 that abuts against a seal forming rib 14 which is molded integrally with the base 10̸. The outwardly directed flange 71 carries a metal ring 73 provided with lugs, (not shown) that engage tapered ramps, (not shown) on the flange 15 of the base forming a bayonet type mount whereby the glass cover and base may be rotated relative to one another to detachably join them together with the rib 14 on the base being pressed against the seat 72 on the glass cover.

The present invention is particularly directed to the bearing system and various parts thereof for the rotor shaft 40̸ and incremental adjustment of the rotor shaft support bearing.

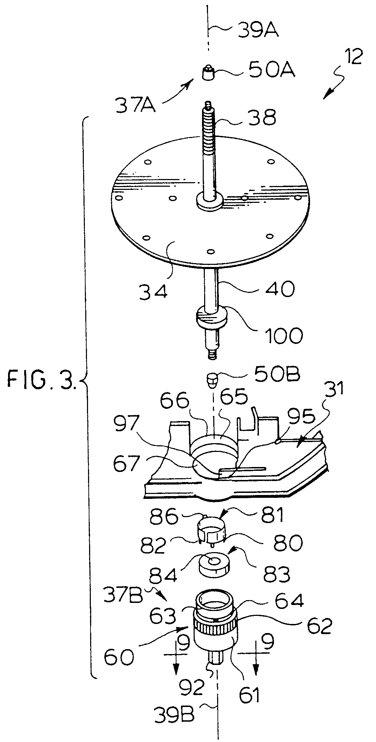

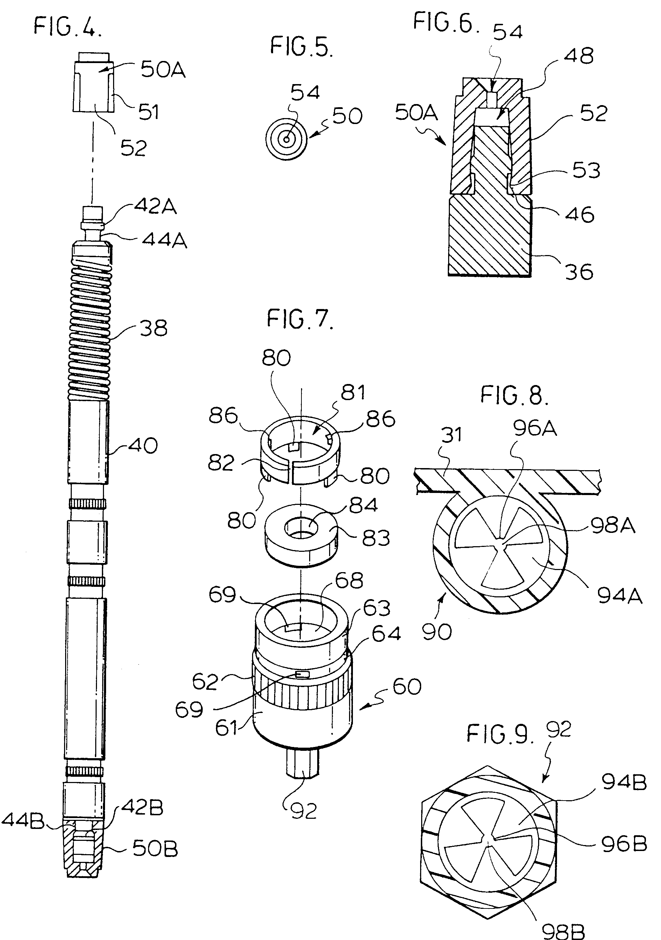

As previously mentioned, there is an upper bearing assembly 37A and a lower bearing assembly 37B. Turning to figure 3 each of the bearing assemblies 37A, 37B include a pilot bearing 50̸A, 50̸B as well as a pintle 39A, 39B, respectively. Each pilot bearing -- in place of known graphite or polymide rings pressed into the end of the spindle as in the prior art -- is a plastic bearing made of, for example, a polyphenylene sulfide compound (PPS) available from Phillips 66 Company under the Trade-Mark Ryton. Turning to figure 4, each pilot bearing is a cap type bearing that snap fits onto the end of the shaft 40̸. Each bearing 50̸A, 50̸B has a series of slits (or areas of reduced strength) 51 that provide a series of legs 52. The legs 52 of the pilot bearings 50̸A, 50̸B flex outwardly to snap onto an enlargement or rib 42A, 42B machined onto a reduced end 44A, 44B of opposite ends of the shaft 40̸. Referencing figure 6, the legs 52 have, on their inner surface, a knob or enlarged portion 53 securely anchoring the pilot bearing to the shaft. The shaft 48 has a shoulder 46 against which the pilot bearing 50̸A abuts ensuring axial alignment of a hole 54 in the end of the bearing with the axis of rotation of the shaft. As is apparent from figure 3, the pintle 39A projects into the hole 54 of the pilot bearing 50̸A and the end of the shaft 48 can serve as an abutment for the pintle 39A if need be but in normal operation there would be no engagement between the pintle and the end of the shaft. Returning to figure 2, the upper end cap bearing 50̸ fits loosely into an opening provided by a lug 36 on the housing 31.

The upper pintle 39A projects into the pintle receiving unit 90̸ which is shown in cross-section in figure 8. Referencing figure 3, one end of lower pintle 39B projects into the bottom pilot bearing 50̸B and the other end of the pintle fits into a downwardly projecting stem portion on a lower bearing support portion 60̸. The lower bearing support is a plastic molded part. The pintle receiving portion 92 of the lower bearing support 60̸ is illustrated in cross-section in Figure 9 which is taken along essentially line 9-9 of Figure 3. Referencing figures 8 and 9, each of the pintle receiving units 90̸, 92 have three equally spaced triangular inwardly directed projections 94A, 94B, respectively, with their apexes directed to a common center. Each apex has a concave area 96A, 96B, respectively on the end thereof partially to embrace the pintle which is press fit into the space 98A, 98B, respectively between the apex of the triangular projections.

Referencing figures 3 and 7, the pintle receiving unit 92 is a downwardly projecting portion of lower, molded plastic, bearing support housing 60̸. Pintle receiving unit 92 has a locating ring portion 61 below ratchet grooves 62 formed about the periphery centrally of the bearing housing. The bearing housing has a sleeve portion 63 with threads 64 formed on the outer surface. These threads mate with threads 65 (figure 3) on a semi-circular part 66 on the molded housing 31. The semi-circular part 66 is co-axial with an annular opening 67 that closely surrounds the bearing support portion 61. With specific reference to figure 7, between the bearing support portions 61 and 63 is a wall 68 having spaced openings 69 for receiving respective ones of a plurality of lugs 80̸ extending downwardly from a metal split sleeve member 81. Sleeve member 81 acts as a temperature compensator. The sleeve is split at 82 so as to snugly receive therein an annular permanent magnet 83 having a central aperture 84. Magnet 83, tightly surrounded by sleeve 81, fits into the recess in the top end of the bearing support 60̸ and is firmly anchored in position by bending over the tabs 80̸ under the wall 68 accessible through access holes 69. The split sleeve member 81 has tabs 86 that are bent inwardly above the magnet holding the magnet captive in the top end of the bearing support.

Returning to figure 3, the lower bearing support 60̸, with the lower support magnet 83 held captive therein by the sleeve 81, threads into the lower end of the housing 31, with threads 64 mating with threads 65. This threaded engagement permits moving the lower bearing support axially along the axis of rotation of the rotor by rotating the bearing housing. The lower pilot bearing 50̸B fits loosely into the opening 84 of the magnet 83 and magnet 83 is disposed closely adjacent an upper support magnet 10̸0̸ secured to the spindle 40̸. Forces of magnets 83 and 10̸0̸ opposing one another support the rotor 34.

The housing 31 has a finger 95 molded integrally therewith (or separately secured thereto) that has a free outer end portion 97 biased into the ratchet grooves 62 on the member 60̸. The finger 95 and grooves 62 provide a ratchet for incremental adjustments in rotating the bearing support housing 60̸ which, when rotated, moves axially along either up or down dependent upon clockwise or counterclockwise rotation so as to adjustably position the rotor assembly. Raising and lowering of assembly positions the disk 34 appropriately within the gap 25 in the electro-magnetic unit 20̸. The lower bearing assembly is readily rotated by turning the hexagonal head of the downwardly protruding pintle receiving unit 92 on the bottom end of the housing 60̸.

It will be readily apparent to those skilled in the art that the snap on end cap pilot bearings may be utilized without the adjustable lower bearing assembly and likewise the lower bearing adjustable assembly may be used with a conventional pilot bearing that is inserted into the end of the shaft.

The register and rotor unit 30̸ disclosed herein has the register secured to the molded plastic housing 31 so as to be positively located relative to the worm drive gear 38. This facilitates assembly with assurance of proper correlation in positioning between the worm drive gear and the driven gear on the register.

The plastics for the molded housing, pilot bearings and meter base are engineering grade resins and preferably rigid thermoplastic materials such as those identified hereinbefore.

## Claims

1. A bearing system for the rotor of an electro-mechanical induction watt hour meter wherein the rotor includes a shaft having a disk mounted thereon for rotation therewith, said bearing system comprising a pair of end cap pilot bearings secured to respective opposite ends of the shaft, said end cap pilot bearings having a pintle receiving aperture disposed in axial alignment with the axis of rotation of the shaft.

2. A rotor bearing system as defined in claim 1 wherein said end cap pilot bearings are resilient and have an internally directed enlargement.

3. A rotor bearing system as defined in claim 2 wherein each of said opposite ends of said shaft has an end portion of reduced thickness with an enlargement thereon such that said pilot bearing is received on said shaft with said end cap pilot bearing enlargement snap fit over said shaft enlargement.

4. A bearing system for the rotor of an electro-mechanical induction watt hour meter wherein the rotor includes a disk secured to a shaft for rotation therewith, said bearing system comprising a pair of end cap pilot bearings secured to a respective one of opposite ends of the shaft, said end cap pilot bearings having a pintle receiving aperture disposed in axial alignment with the axis of rotation of the shaft and a magnetic bearing support means at the lower end of the shaft comprising a first and second permanent magnet secured respectively to said shaft and an adjustable support means.

5. A bearing system as defined in claim 4 wherein said second permanent magnet has a central aperture therein loosely receiving an end cap pilot bearing on the lower end of the shaft and wherein said second magnet is mounted in a support housing threadingly mounted for adjustment in a direction back and forth along the axis of the shaft.

6. An electro-mechanical induction meter, comprising:
(a) a molded housing having an upper bearing guide and a lower bearing guide and support means;
(b) a shaft having a disk secured thereto for reacting to induced flux fields of an electro-magnetic system;
(c) a pair of end cap bearings one secured to each of opposite ends of said shaft and co-operating with said respective upper and lower guide means;
(d) said lower bearing guide and support means comprising a first permanent magnet secured to said shaft for rotation therewith and a second permanent magnet; and
(e) controllably adjustable support means on said housing supporting said second permanent magnet for selective incremental movement in a direction along the axis of rotation of said shaft.

7. A device as defined in claim 6 wherein said second magnet is an annular member receiving therein an end cap pilot bearing secured to the shaft and including a metal sleeve surrounding said magnet holding the same captive on said adjustable bearing support means.

8. A device as defined in claim 7 wherein said sleeve is a split sleeve tightly embracing said magnet associated therewith.

9. An electro-mechanical induction watt hour meter having a rotor comprising a shaft with a disk secured thereto for rotation therewith and a lower magnetic bearing means supporting said rotor, said magnetic bearing means comprising an upper and a lower permanent magnet secured respectively to said shaft and a bearing support means and means mounting said bearing support means for selective controllable adjustment.

10. Apparatus as defined in claim 1, 2, 3, 4 or 5 including a pair of pintles comprising slender pins projecting into a respective one of said apertures and including means mounting respective ones of said pintles in spaced relation relative to the end cap pilot bearing associated therewith.

11. Apparatus as defined in claim 1, 2, 3, 4 or 5 including a pair of pintles comprising slender pins projecting into a respective one of said apertures and including means mounting respective ones of said pintles in spaced relation relative to the end cap pilot bearing associated therewith, said pintle mounting means comprising spaced apart projections for the respective pintles having apexes directed to a common centre, said apexes being spaced from one another and wherein an end portion of the pintle fits into said space in friction fit relation with said apexes.

12. Apparatus as defined in claim 1, 2, 3, 4 or 5 mounted on a molded register housing.

13. Apparatus as defined in claim 1, 2, 3, 4 or 5 mounted on a molded register housing, a pair of pintles comprising slender pins projecting into a respective one of said apertures, means mounting respective ones of said pintles in spaced relation relative to the end cap pilot bearing associated therewith on said housing comprising spaced apart projections for the respective pintles having apexes directed to a common centre, said apexes being spaced from one another and wherein and end portion of the pintle fits into said space in friction fit relation with said apexes.
